# EUROPEAN PATENT SPECIFICATION

(11) **EP 3 588 108 B1**
(45) Date of publication and mention of the grant of the patent: **14.09.2022**
(21) Application number: 18180870.0
(22) Date of filing: 29.06.2018
(51) Int. Cl.: G01R 31/12

(54) **METHOD AND DEVICE FOR USE OF MULTIPLE FREQUENCIES PRPD PATTERN TO REDUCE NOISE OR SELECT SUITABLE FREQUENCY RANGES FOR PARTIAL DISCHARGE MEASUREMENTS**
VERFAHREN UND VORRICHTUNG ZUR VERWENDUNG EINES MEHRFREQUENZ-PRPD-MUSTERS ZUR RAUSCHREDUKTION ODER AUSWAHL GEEIGNETER FREQUENZBEREICHE FÜR TEILENTLADUNGSMESSUNGEN
PROCÉDÉ ET DISPOSITIF PERMETTANT D'UTILISER UN MOTIF PRPD À FRÉQUENCES MULTIPLES POUR RÉDUIRE LE BRUIT OU SÉLECTIONNER DES GAMMES DE FRÉQUENCES APPROPRIÉES POUR DES MESURES DE DÉCHARGE PARTIELLE

(43) Date of publication of application: 01.01.2020
(73) Proprietor: ABB Schweiz AG, 5400 Baden (CH)
(72) Inventor: Maret, Yannick, 5405 Daettwil (CH); Hencken, Kai, 79539 Lörrach (DE)
(74) Representative: Zimmermann & Partner Patentanwälte mbB

(56) References cited:
- US-A1- 2004 204 873
- US-A1- 2008 088 314
- US-A1- 2009 119 035
- US-A1- 2013 179 100

## Description

### FIELD OF INVENTION

The invention is in the field of monitoring the status of dielectric strength of a high-or medium voltage installation, preferably in the Medium Voltage area. Embodiments of the present disclosure may generally relate to measure partial discharge events in medium- or high voltage installations. In particular, embodiments of the present disclosure relate to a method and a device for acquiring and analyzing Phase Resolved Partial Discharge (PRPD) patterns.

### BACKGROUND OF INVENTION

Most Partial Discharge (PD) measurement systems use, up to now, a single frequency band, often chosen according to IEC standard or based on some signal-to-noise criteria. In IEC 60270, a standard PD measurement system based on a capacitive coupling to the high-voltage together with a blocking impedance is disclosed. PD can be measured by looking at the effects of charges flowing during the partial discharge event. This flow of charges results in temporary voltage changes, caused by the partial discharge, on the high-voltage line.

Partial Discharge usually begins within voids, cracks, or inclusions within a solid dielectric, at conductor-dielectric interfaces within solid or liquid dielectrics, or in bubbles within liquid dielectrics. Since partial discharges are limited to only a portion of the insulation, the discharges only partially bridge the distance between electrodes. Partial discharge can also occur along the boundary between different insulating materials. Within an insulating material, partial discharges are usually initiated within gas-filled voids within the dielectric. The electric field and the critical field strength of the void is different from those of the surrounding material: typically, the former is larger and the latter smaller for the void than the surroundings. If the voltage across the whole insulator is increased, such that the field strength within the void is above its critical value, partial discharge activity will start within the void.

Partial discharges can also occur along the surface of solid insulating materials, if the surface tangential electric field is high enough to cause a (partial) breakdown along the insulator surface. Partial discharge measurements are an important technique to assess this.

In most systems measuring partial discharges, a frequency band used for measuring is fixed by design, i.e. the system acquires data only at that frequency range. Alternatively, different frequency ranges may be scanned during commissioning and, based on a global signal-to-noise indicator, a single suitable band is selected.

In online installations the detection and removal of external disturbances is of high importance. Such disturbances are often produced by e.g. the equipment attached to the high-voltage conductors leaving the substation or high-power system in the vicinity of the measurement system. As the external perturbations may often originate from power electronics or other switched devices, they are not as wideband signals as real PD: they may only appear in specific frequency bands. In addition, these disturbances are not present at all times. If they were not during the installation (or the calibration of the PD measurement system), they could interfere or even be mistaken for PDs during online monitoring. It is therefore of high relevance to be able to detect and suppress external disturbances of this type. This detection principle can be furthermore used to avoid measuring in frequency bands that are compromised by external disturbances.

Distinguishing PD and noise (also distinguishing different PD types) is an important issue and many different techniques have been proposed. For example, different PD types and noise exhibit different pulse shapes so that analyzing the time-domain signal pattern allows disentangling PD signals from noise.

This can however only be achieved by acquiring the signal with sampling rates in the 100 MHz or higher range, because PD is a very short-time phenomena (in the range of 10 ns to 100 ns). For a low-cost PD system (suitable for online monitoring in the MV range), this high-speed acquisition is clearly too costly.

Alternatively, an initial frequency scan is often performed during commissioning in order to select regions with low noise content. Whereas this can be suitable for laboratory or diagnostics measurements, where the PD is acquired only for a short time, it is believed, that this approach is an unsuitable option for online monitoring system, as external disturbances can appear or disappear rather randomly over time.

Simultaneously measuring individual peaks within different frequency bands in order to simultaneously use their content to classify the peaks as PD or noise is also a known method.

It has already been proposed to acquire each PD peak in a number of discrete frequency bands and to jointly analyses peaks in the different bands. This approach however requires a parallel data acquisition, i.e. the contents of each band should be acquired at the same time. This approach would make such a solution rather expensive and would limit the number of bands to a handful (typically two or three).

### SUMMARY OF INVENTION

In order to address the foregoing and other potential problems, the invention is defined by the embodiments according to the method of claim 1 and the apparatus of claim 6. Further embodiments are defined in the dependent claims. Additionally to the embodiments of the invention, the description and drawings also define further aspects, examples, implementations, and non-claimed embodiments for the better understanding of the claimed invention. Embodiments of the present disclosure propose:

In a first aspect, a method for determining and processing phase resolved partial discharge patterns is disclosed. The method may comprise: determining, in a sequentially manner, on at least one high-voltage conductor at least two phase resolved partial discharge patterns with a partial discharge monitoring system in a medium or high voltage compartment in different frequency ranges. Processing, with a processing unit, the phase resolved partial discharge patterns to achieve electronically processible data. Storing the electronically processible data of the phase resolved partial discharge pattern in a memory area, separately for each determined pattern. Processing the data of the phase resolved partial discharge patterns with the electronic data processing unit. In particular, the processing unit may merge the patterns, or a subset thereof, into a single phase resolved partial discharge pattern. A subset of a Phase Resolved Partial Discharge pattern may concern one or several regions of a pattern which are characterised by a given phase range and/or amplitude range.

The processing unit may be further configured to pre-classify the patterns, or a subset thereof whether they contain mostly partial discharges or partial discharges and values related to noise. The processing unit may employ a specific algorithm for this purpose. In a further embodiment, a "similarity" between a number of counts in each pattern can be considered in the analysis.

In a further aspect, a device adapted to carry out the method according to any one of the previous method embodiments is provided, with: a partial discharge monitoring system, configured to sequentially determining, on at least one high-voltage conductor, at least two phase resolved partial discharge patterns in different frequency ranges; a processing unit, adapted to process the phase resolved partial discharge patterns to achieve electronically processible data; a storage area, adapted to store the electronically processible data of the phase resolved partial discharge pattern, separately in a memory area for each determined pattern. The processing unit may further be adapted to process the data of the phase resolved partial discharge patterns to classify the patterns, whether they may contain mostly partial discharges or may contain partial discharges and values related to noise.

### BRIEF DESCRIPTION OF DRAWINGS

Embodiments of the present disclosure will be presented in the sense of examples and their advantages are explained in greater detail below, with reference to the accompanying drawings, wherein:
FIG. 1 illustrates an embodiment of different approaches to remove disturbances in a multi-frequency setting;
FIG. 2 shows a PD pattern in a frequency range;
FIG. 3 shows the PD pattern of Fig. 2 in another frequency range;
FIG. 4 shows the PD pattern of Fig. 3 in another frequency range;
FIG. 5 shows a PD pattern according to IEC
FIG. 6 illustrates embodiments of methods of the present disclosure.

### DETAILED DESCRIPTION OF EMBODIMENTS

The disclosed subject matter will now be described with reference to the attached figures. Various structures, systems and devices are schematically depicted in the drawings for purposes of explanation only and so as to not obscure the description with details that are well known to those skilled in the art. Nevertheless, the attached drawings are included to describe and explain illustrative examples of the disclosed subject matter. The words and phrases used herein should be understood and interpreted to have a meaning consistent with the understanding of those words and phrases by those skilled in the relevant art. No special definition of a term or phrase, i.e. a definition that is different from the ordinary and customary meaning as understood by those skilled in the art, is intended to be implied by consistent usage of the term or phrase herein. To the extent that a term or phrase is intended to have a special meaning, i.e. a meaning other than that understood by skilled artisans, such a special definition will be expressly set forth in the specification in a definitional manner that directly and unequivocally provides the special definition for the term or phrase.

The invention discloses an analysis approach to measure Partial Discharge (PD) in order to evaluate problems and status of insulation systems.

It is proposed to sequentially acquire a multitude of phase-resolved partial discharge (PRPD) patterns at different frequency ranges - that is the PRPD may be acquired in a time-multiplexed way rather than simultaneously. Statistical analysis of the individual patterns, and of their correlation, may be subsequently performed in order to decide whether individual or group of patterns (e.g. acquired at one or several frequency intervals), or a subset thereof, are consistent with the assumption that the patterns are originating from a PD defect. The fact is used, that PDs are very short events (delta-pulse like) that are visible in wide frequency ranges (a range in MHz and sub-MHz is considered) and that PRPD patterns, a summary of multiple PD pulses, are stable over a larger period of time (e.g. minutes).

On the other hand, external noise is, in most cases, only visible in discrete individual frequency bands. This analysis may then be used to either correct or remove external disturbances in specific bands (e.g. those preferred by the IEC standard), or alternatively to avoid bands which are not suitable for PD measurement (due to external disturbances dominating the PRPD pattern).

The proposed statistical approach, based on time multiplexing, has the advantage that it does not require a multitude of simultaneous data acquisition paths (i.e. one for each frequency band). This may result in reduced cost, making the approach more suitable for e.g. MV online installation. Compared to "standard frequency scanning" approaches, the frequency band selection may not be based on an initial (offline) calibration run. The decision is rather based on the details of the (online) acquired PRPD pattern. The proposed approach may account for noise present at the time of the online measurement and can thus adapt to varying situations.

This method of analyzing a multitude of PRPD patterns is not on the level of using individual PD events, but rather based on the usage of full PRPD patterns. The proposed method can be used to analyze whether PRPDs at different frequencies are consistent with a PD source, that is to say, whether the pattern only or mostly contains partial discharge events, or whether some of them have been corrupted by external perturbations, like noise generated by external electronic circuits, adjacent radio transmitters, or the like.

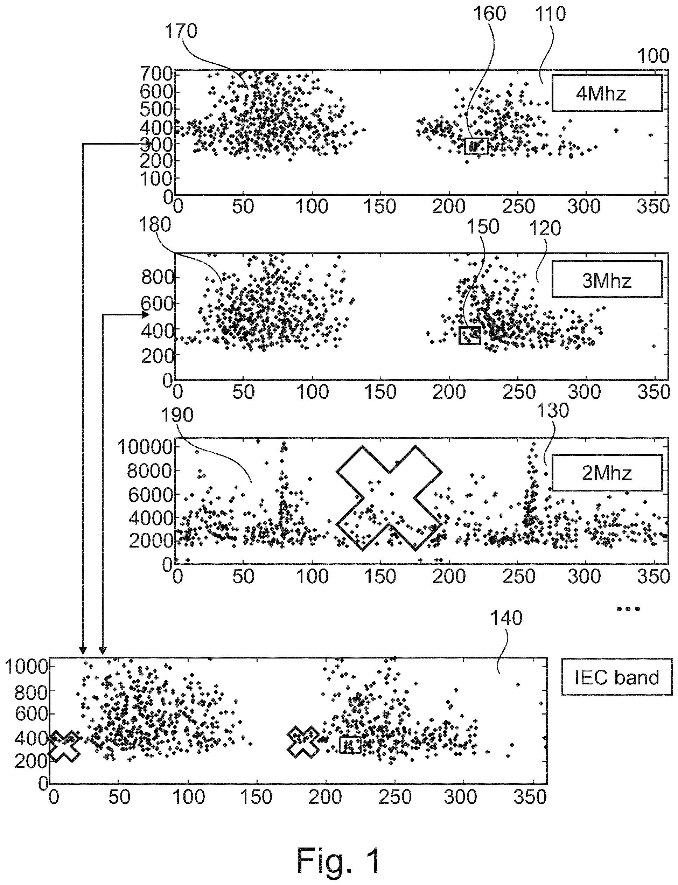

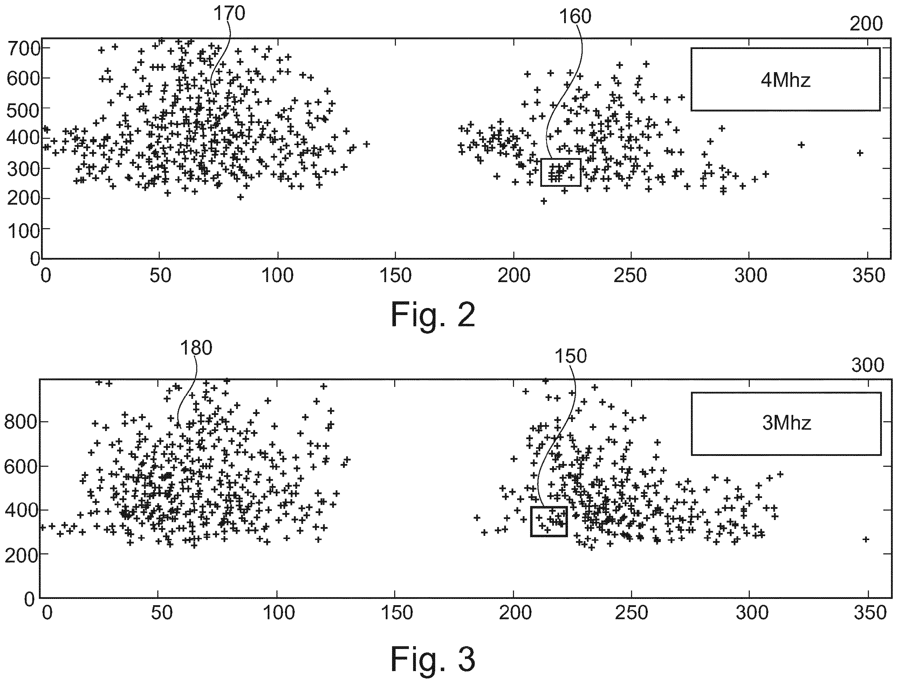

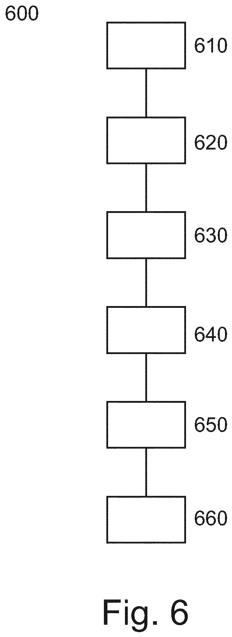

Therefore, in a first aspect (Fig. 6), a method 600 for determining and processing phase resolved partial discharge patterns is disclosed. The method may comprise: determining 610, in a sequentially manner, on at least one high-voltage conductor at least two phase resolved partial discharge patterns with a partial discharge monitoring system in a medium or high voltage compartment in different frequency ranges, as can be seen in Fig. 1 and, in particular, in Fig. 2 and Fig. 3. That is to say, the partial discharge patterns may preferably be acquired one after another.

The at least two phase resolved partial discharge patterns can alternatively be determined with a partial discharge monitoring system in a medium or high voltage compartment by using different methods or measurement parameters.

Processing 620, with a processing unit, the phase resolved partial discharge patterns to achieve electronically processible data; storing 630 the electronically processible data of the phase resolved partial discharge pattern in a memory area, separately for each determined pattern (i.e. PRPD in different frequency bands); and processing 640 the data of the phase resolved partial discharge patterns with the electronic data processing unit that is further configured to classify the patterns or a subset thereof, whether they contain mostly partial discharges or partial discharges and values related to noise.

A PRPD pattern may be generated in the form of an N x M matrix, where columns can correspond to a phase of a frequency which the powerline voltage has (in Europe a 50 Hz signal). The phase of the powerline voltage is typically ranging from 0 to 360 degrees, respectively 0 to 2π radian.

Rows of the N x N matrix may correspond to a PD amplitude from 0 to max pC. C stands for unit "Coulomb", which designates "charge". Each time a partial discharge can be detected, the corresponding entries can be increased by one (i.e. the PD counts are accumulated). In the end, each entry in the matrix may correspond to how many partial discharges of that amplitude and at that high-voltage conductor phase were detected.

In a further approach, a measurement system or method, which is compliant with the IEC standard, see Fig. 1, 140, may be improved. The measurement system compliant to IEC standard requires, that a certain frequency range is selected. The frequency range may be split into two types: within the frequency ranges required by the IEC and above this frequency range. The PRPD of the latter type are only used for the removal of noise from the patterns of the former type (i.e. within the IEC frequency). By this approach, it may be possible to remove noise, however, results can advantageously still be presented in agreement with the IEC standard.

In yet a further approach, a pre-processing step may be introduced in order to allow the above methods on PRPD patterns or individual peaks that are not calibrated in PD strength. In this pre-processing step, the relative PD strength of the different frequency bands may be determined by maximizing the pattern correlation between the bands.

Additionally, a "similarity" between a number of counts in each acquired pattern can be considered in a further analysis.

In a further embodiment, the different frequency ranges may be in an acoustical frequency range, and can be measured with a measurement unit adapted to measure signals in the acoustical frequency (e.g. a microphone). Partial discharges may generate acoustically receivable noise, comparable to the sound, which is generated by electrical sparks. Such a noise can e.g. be received or measured with specifically adapted microphones or specific measurement equipment.

A merging of Phase Resolved Partial Discharge patterns may preferably not only concern patterns acquired in different frequency ranges, but also patterns acquired under different modalities or using different measurement principles or systems. This may comprise any pattern acquired using an acoustic measurement approach, using a microphone, or patterns acquired from e.g. different sensors installed at different places inside the switchgears or in a transformer. In other words, patterns acquired with different measurement methods, in different frequencies and in different locations of an installation may be merged to get an overall picture of a partial discharge situation in this installation. The installation can be located in a power plant or can be a switching station, distribution station, a relay station or a voltage transformation substation. The listing is not considered to be exhaustive or limiting.

The frequency ranges can be also in an RF-frequency range (RF = radio frequency). To measure these ranges (e.g., but not limited to, in the UHF = ultra-high frequency range), specifically adapted antennas or couplers may be employed.

In a further embodiment it may be disclosed, that the phase resolved partial discharge patterns may be acquired 660 in a sequenced manner or, alternatively, in an interleaved manner. Interleaved manner means here, building a portion of a PRPD pattern (e.g. for frequency range f0) at a time n=0, after that, building a second PRPD pattern at a time n=1 (say for frequency range f1), then continuing the PRPD pattern for f0 at time n=2, then f1 at n=3, and so forth.

In this case, each time step n has a duration in the range of several seconds (or shorter) whereas the full pattern for a given frequency may take minutes or longer to build. The more individual partial discharges are accumulated, the more 'accurate' a PRPD pattern may be generated.

As the partial discharge process may produce a limited number of measurable discharges within a given time interval, the PRPD creation process cannot be arbitrarily fast. The number of partial discharge depends on the type and characteristics of the defect producing them. In the end, minutes is a good order of magnitude for the duration to acquire a meaningful pattern.

In a further embodiment, the partial discharge monitoring system may be adapted to be electrically coupled to a coupler. The coupler may be configured to receive electrical signals generated by a partial discharge event. The coupler can be a capacitive coupler. Preferably, the coupler can be the coupler which may be also used by a Voltage Indicator System which may also be present in the medium- or high voltage installation.

In yet a further embodiment, the memory area may be a memory area in the data processing unit, the data processing unit may comprise a CPU, memory to store data and program code and circuitry for inputting/outputting data.

In another embodiment, it may be disclosed that the device may be adapted to carry out a method according to one or more disclosed embodiments. The device may comprise: a partial discharge monitoring system configured to sequentially determine, on at least one high-voltage conductor, at least two phase resolved partial discharge patterns in different frequency ranges; a processing unit, adapted to process the phase resolved partial discharge patterns to achieve electronically processible data, a storage area, adapted to store the electronically processible data of the phase resolved partial discharge pattern, separately in a memory area for each determined pattern, the processing unit further being adapted to process the data of the phase resolved partial discharge patterns to classify the patterns, whether they contain mostly partial discharges or partial discharges and values related to noise.

In another embodiment, the device may be adapted to determine additional phase resolved partial discharge patterns at different frequencies each. The different frequencies may be in a range of acoustical frequencies or RF frequencies (e.g. UHF, HF = high frequency range, or LF = low frequency range).

According to an embodiment, the partial discharge monitoring system of the device may be electrically coupled to a coupler which may be capable of receiving electrical signals generated by a partial discharge.

According to an embodiment, the memory area may be a memory area, located in the data processing unit, the data processing unit may comprise a CPU, memory to store data and program code and circuitry for inputting/outputting data.

According to an embodiment, the processing unit in some aspects of the invention, may be configured to combine patterns, or subset(s) thereof, classified as containing mostly partial discharges into a single pattern. This reduces overhead, and speeds up the analysis.

In some aspects of the presented device or method, the decision on whether one measurement is considered to contain values related to noise, may be based on a distance metric that may compare the pattern of each frequency range with each other.

In further aspects of the presented method or device, it may be disclosed that a comparison of the different measurements is performed such that the comparison is independent of the overall strength with which the PD pulse is acquired. Generally, a normalisation factor can be considered as referring several different values to one specific normalisation value. It may be defined that e.g. the highest value may be "1" and so all values are set in a relation which each other.

In further aspects of the presented method or device, the comparison between measurements in the different frequency ranges may be due to a "binning" of both the phase and the PD strength and using a statistical frequency (or count or event frequency) of Partial Discharge events in each bin, see Figs 1, 2, 3 and 5, items 150 and 160.

In Fig. 1, PD counts at frequencies 2Mhz, 3 Mhz and 4Mhz are illustrated. "clouds" of counts 170, 180, 190 are shown. The x- axis in Figs. 1 to 5 relate to phase values (power line voltage) from 0 to 360 degree respectively 0 to 2π radian, the y-axis relates to an amount of charge of a partial discharge event, measured in pico Coulomb (pC).

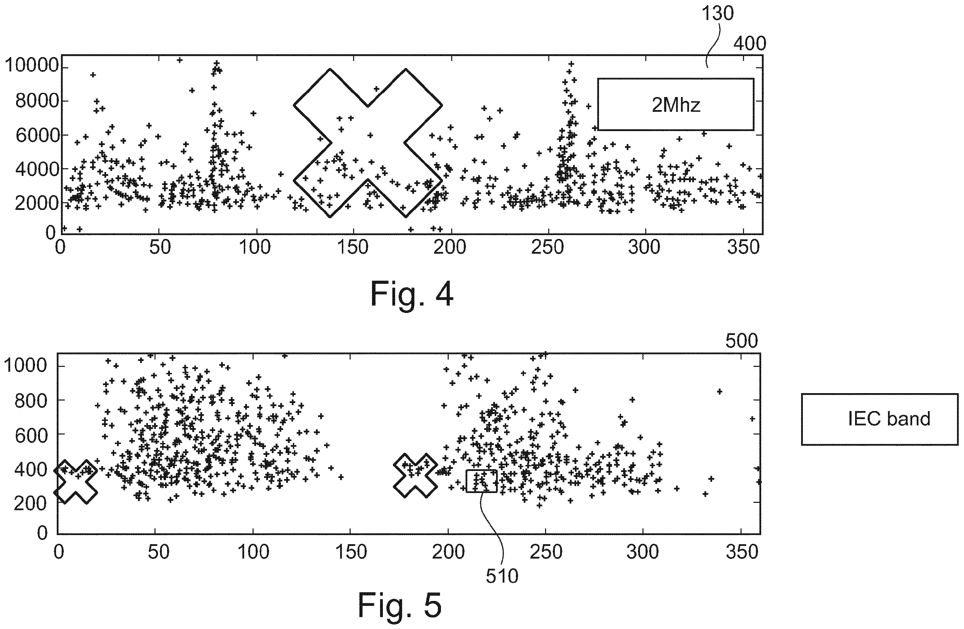

Figs. 2 and 3 show in 170 and 180 "clouds" of partial discharges (counts). Areas 150 and 160 illustrate the "bins", which may help to compare PDs at a specific phase and PD strength. In these two figures, frequency range 3 Mhz (item 120 in Fig. 1) and frequency range 4 Mhz (item 110 in Fig. 1) may be relatively free of noise. Fig. 4 shows the 2 Mhz frequency range 130, and a "crossed" area, containing noise values.

The IEC band, illustrated by 140 in Fig. 1, in the 2Mhz frequency range may show a combination of noise values and PD (Fig. 1, lower part and Fig. 5 "cross" + "bin" 510)

An analysis can be based on statistical test procedures, which compare individual PRPD patterns and identify those, which are different (in some predetermined aspects) in a statistically significant way.

For example, the PRPD pattern can be split into bins 150, 160 in both the phase and PD strength direction. The number of signals within these bins 150, 160 can be used as a basis for a statistical test. E.g. assuming a Poisson distribution, the number of counts in all other frequencies may be used in order to estimate a parameter of the distribution. A single-sided test may be subsequently performed and, if the number of counts for the frequency under investigation may be too large, the entries in this bin 150, 160 are assumed to be due to external disturbances, as they are visible only in one range. All entries within this bin 150, 160 may be preferably then flagged as being noise and are preferably not used for any further analysis.

Alternatively, a judgment or significance test can be performed for each acquired peak. By choosing a suitable range around an individual peak and, again, comparing the number of counts in other frequency bands, the individual peak can be assigned the information, whether it is noise or partial discharge. Such a system may avoid the selection of bins and can be implemented as well in an online approach.

Based on the analysis of individual bins 150, 160, a judgement about a likelihood can be made, that a specific frequency band is polluted with some external disturbances. For example, individual p-values (phase values) of each bin 150, 160 can be combined into a global one. Alternative methods are goodness-of-fit tests, which may compare an empirical two-dimensional probability distribution function and can flag 'outliers' among different bands.

In this way, the proposed approach may be able to remove external disturbances from each PRPD pattern and, for example, may further be able to combine the pattern in an overall pattern that can be further analyzed or shown to the operator for further judgement. In addition, it is enabled to avoid problematic frequency ranges in future analysis, focusing on those ranges, which are devoid of external perturbations.

In a further embodiment, selected frequency ranges may be excluded from a further analysis. Such an exclusion decision may be based on a result of the comparison provided by aspects of the method of the device. This frequency ranges, in other words, may be completely "blacklisted" for the further analysis, which makes the analysis faster, since no useless data, which do not contribute to a result, have to be considered.

According to embodiments, the device or method, according to disclosed aspects, further discloses that, based on a result of the comparison within certain regions within a PRPD pattern, these certain regions can be excluded from a further analysis. In other words, regions, which obviously may contain noise values, as e.g. the values measured in the 2 MHz band in Fig. 4, can be excluded or "black listed" from a further analysis. This e.g. may speed up the process, since these specific values are not further considered in calculating.

According to an aspect of the present disclosure, an exclusion of regions, based on the comparison result may also relate to certain regions in only one pattern or in a subset of patterns. An exclusion does not necessarily mean, that a complete acquired PRPD pattern is excluded from further analysis as a whole. However, it may be possible, that one or more complete acquired patterns are removed from further analysis, dependent on how much useful data they contain. Generally, this procedure reduces the processing load of a processing unit and may speed up the analysis process. Alternatively the combination makes use of those remaining information, which contains information regarding the PD pattern and improves the overall pattern quality.

A further aspect of the present application concerns and discloses, that different measurements, performed by a device or a method according to further described aspects, can be combined into a total or "overall" PRPD pattern. The latter aspect may also contain a normalization of the measured values.

The new overall PRPD pattern can serve as a basis for further analysis, e.g. for a classification algorithm or can be presented to an operator which is enabled to take further measures, based on the presented patterns.

According to another aspect, the device may further comprise a network interface for connecting the device to a data network, in particular a global data network. The data network may be a TCP/IP network such as internet. The data network may further comprise distributed storage units such as Cloud. The data network may also use WLAN, WAN or Internet. Depending on the application, the Cloud can be in form of a public, private, hybrid or community Cloud.

The device may operatively be connected to the network interface for the purpose of carrying out commands received from the data network. The commands may include a control command for controlling the device to carry out a task, such as to start a PRPD measurement or to start an analysis based on measured PRPD patterns.

In this case, the device or controller is adapted for carrying out the task in response to the control command. The commands may include a status request. In response to the status request, or without prior status request, the device or controller may be adapted for sending a status information to the network interface, and the network interface can be adapted for sending the status information over the network. The commands may include an update command including update data. In this case, the device or controller can be adapted for initiating an update in response to the update command and using the update data.

According to aspects, embodiments of the presented application may comprise a network interface for connecting the device of the present application to a data network, wherein a device or controller is operatively connected to the network interface for at least one of carrying out a command received from the data network and sending device status information to the data network. In further aspects, embodiments of the application may comprise a processing unit for converting an acquired and/or processed and/or analyzed signal into a digital signal.

Embodiments of the present application may comprise a network interface for connecting devices, presented in embodiments of the present disclosure, to a network, wherein the network interface may be configured to transceive digital signals or data between the device and the data network, wherein the digital signals or data may include operational command and/or information about the device or the network.

## Claims

1. A method (600) for determining and processing phase resolved partial discharge patterns, comprising:
- determining (610), in a sequential manner, on at least one medium-voltage or high-voltage conductor at least two phase resolved partial discharge patterns with a partial discharge monitoring system in a medium-voltage or high-voltage compartment in different frequency ranges;
- processing (620), with a processing unit, the phase resolved partial discharge patterns to achieve electronically processible data;
- storing (630) the electronically processible data of the phase resolved partial discharge pattern in a memory area, separately for each determined pattern;
- processing (640) the data of the phase resolved partial discharge patterns with the electronic data processing unit that is further configured to classify the patterns, or a subset thereof, whether they contain mostly partial discharges or partial discharges and values related to noise.

2. The method (600) according to claim 1, wherein the different frequency ranges can be in an acoustical frequency range, measured with a measurement unit adapted to measure signals in the acoustical frequency range, or
wherein the frequency ranges are in an RF-frequency range.

3. The method (600) according to any one of the previous claims, wherein the phase resolved partial discharge patterns are acquired in a sequenced manner or in an interleaved manner.

4. The method (600) according to any one of the previous claims, wherein the partial discharge monitoring system is electrically coupled to a coupler which is configured to receive electrical signals generated by a partial discharge.

5. The method (600) according to any one of the previous claims, the memory area is a memory area in the data processing unit, the data processing unit comprising a CPU, memory to store data and program code, and circuitry for inputting/outputting data.

6. A device adapted to carry out the method according to any one of the previous claims, with:
- a partial discharge monitoring system, configured for sequentially determining, on at least one medium-voltage or high-voltage conductor, at least two phase resolved partial discharge patterns (170, 180) in different frequency ranges (110, 120, 130) or acquired via a different measurement principle;
- a processing unit, adapted to process the phase resolved partial discharge patterns to achieve electronically processible data;
- a storage area, adapted to store the electronically processible data of the phase resolved partial discharge pattern (100, 200, 300, 400, 500), separately in a memory area for each determined pattern;
- the processing unit further adapted to process the data of the phase resolved partial discharge patterns (100, 200, 300, 400, 500) to classify the patterns, whether they contain mostly partial discharges or partial discharges and values related to noise.

7. The device according to claim 6, wherein the partial discharge monitoring system is electrically coupled to a coupler, which is capable of receiving electrical signals generated by a partial discharge.

8. The device according to any one of the preceding claims 6 to 7, wherein the memory area is a memory area located in the data processing unit, the data processing unit comprising a CPU, a memory to store data and program code, and circuitry for inputting/outputting data.

9. The device or the method according to any one of the preceding claims, wherein the processing unit is further configured to combine patterns, or subset(s) thereof, classified as containing mostly partial discharges into a single pattern.

10. The device or method according to any one of the previous claims, wherein a decision on whether one measurement is considered to contain values related to noise, is based on a distance metric, or based on a statistical test that compares the patterns of each frequency range with each other.

11. The device or the method according to any one of the previous claims, wherein a comparison of the different measurements is performed such that the comparison is independent of the overall strength, with which the PD pulse is acquired.

12. The device or the method according to any one of the previous claims, wherein the comparison between measurements in the different frequency ranges is due to a binning (150, 160) of both the phase and the PD strength and using the counts of PD events in each bin (150, 160); and/or wherein, based on a result of the comparison, selected frequency ranges are excluded from a further analysis.

13. The device or the method according to any one of the previous claims, wherein, based on a result of the comparison within certain regions within a PRPD pattern, the certain regions are excluded from a further analysis.

14. The device or the method according to any one of the previous claims, wherein the different measurements are combined into an overall PRPD pattern, which is then presented to an operator or is used as a basis for a further analysis.

15. The device or the method according to any one of the previous claims, wherein the device further comprises a network interface for connecting the device to a data network, wherein the device is operatively connected to the network interface for at least one of: carrying out a command received from the data network and sending device status information to the data network.

## Patentansprüche

1. Verfahren (600) zum Bestimmen und Verarbeiten von phasenaufgelösten Teilentladungsmustern, umfassend:
- sequentielles Bestimmen (610) von mindestens zwei phasenaufgelösten Teilentladungsmustern an mindestens einem Mittel- oder Hochspannungsleiter mit einem Teilentladungsüberwachungssystem in einem Mittel- oder Hochspannungsraum in verschiedenen Frequenzbereichen;
- Verarbeiten (620) der phasenaufgelösten Teilentladungsmuster mit einer Verarbeitungseinheit, um elektronisch verarbeitbare Daten zu erhalten;
- Speichern (630) der elektronisch verarbeitbaren Daten des phasenaufgelösten Teilentladungsmusters in einem Speicherbereich getrennt für jedes ermittelte Muster;
- Verarbeiten (640) der Daten der phasenaufgelösten Teilentladungsmuster mit der elektronischen Datenverarbeitungseinheit, die ferner dazu ausgelegt ist, die Muster oder eine Teilmenge davon dahingehend zu klassifizieren, ob sie hauptsächlich Teilentladungen oder Teilentladungen und Werte im Zusammenhang mit Rauschen enthalten.

2. Verfahren (600) gemäß Anspruch 1, wobei die verschiedenen Frequenzbereiche in einem akustischen Frequenzbereich liegen können, gemessen mit einer Messeinheit, die dazu angepasst ist, Signale im akustischen Frequenzbereich zu messen, oder wobei die Frequenzbereiche in einem HF-Frequenzbereich liegen.

3. Verfahren (600) gemäß einem der vorhergehenden Ansprüche, wobei die phasenaufgelösten Teilentladungsmuster aufeinanderfolgend oder verschachtelt erfasst werden.

4. Verfahren (600) gemäß einem der vorhergehenden Ansprüche, wobei das Teilentladungsüberwachungssystem elektrisch mit einem Koppler gekoppelt ist, der dazu ausgelegt ist, elektrische Signale zu empfangen, die durch eine Teilentladung erzeugt werden.

5. Verfahren (600) gemäß einem der vorhergehenden Ansprüche, wobei der Speicherbereich ein Speicherbereich in der Datenverarbeitungseinheit ist und die Datenverarbeitungseinheit eine CPU, einen Speicher zum Speichern von Daten und Programmcode und eine Schaltungsanordnung zum Eingeben/Ausgeben von Daten umfasst.

6. Vorrichtung zum Durchführen des Verfahrens gemäß einem der vorhergehenden Ansprüche, mit:
- einem Teilentladungsüberwachungssystem, das dazu ausgelegt ist, an mindestens einem Mittel- oder Hochspannungsleiter sequentiell mindestens zwei phasenaufgelöste Teilentladungsmuster (170, 180) in verschiedenen Frequenzbereichen (110, 120, 130) zu ermitteln oder über ein anderes Messprinzip zu erfassen;
- einer Verarbeitungseinheit, die dazu angepasst ist, die phasenaufgelösten Teilentladungsmuster zu verarbeiten, um elektronisch verarbeitbare Daten zu erhalten;
- einen Speicherbereich, der dazu angepasst ist, die elektronisch verarbeitbaren Daten des phasenaufgelösten Teilentladungsmusters (100, 200, 300, 400, 500) getrennt in einem Speicherbereich für jedes ermittelte Muster zu speichern;
- der Verarbeitungseinheit, die ferner dazu angepasst ist, die Daten der phasenaufgelösten Teilentladungsmuster (100, 200, 300, 400, 500) zu verarbeiten, um die Muster dahingehend zu klassifizieren, ob sie hauptsächlich Teilentladungen oder Teilentladungen und Werte im Zusammenhang mit Rauschen enthalten.

7. Vorrichtung gemäß Anspruch 6, wobei das Teilentladungsüberwachungssystem elektrisch mit einem Koppler gekoppelt ist, der in der Lage ist, elektrische Signale zu empfangen, die durch eine Teilentladung erzeugt werden.

8. Vorrichtung gemäß einem der vorhergehenden Ansprüche 6 bis 7, wobei der Speicherbereich ein Speicherbereich ist, der sich in der Datenverarbeitungseinheit befindet, wobei die Datenverarbeitungseinheit eine CPU, einen Speicher zum Speichern von Daten und Programmcode und eine Schaltungsanordnung zum Eingeben/Ausgeben von Daten umfasst.

9. Vorrichtung oder Verfahren gemäß einem der vorhergehenden Ansprüche, wobei die Verarbeitungseinheit ferner dazu ausgelegt ist, Muster oder Untermengen davon, die als überwiegend Teilentladungen enthaltend klassifiziert sind, zu einem einzelnen Muster zu kombinieren.

10. Vorrichtung oder Verfahren gemäß einem der vorhergehenden Ansprüche, wobei eine Entscheidung, ob eine Messung mit Rauschen zusammenhänge Werte enthält, auf einer Abstandsmetrik oder auf einem statistischen Test basiert, der die Muster jedes Frequenzbereichs miteinander vergleicht.

11. Vorrichtung oder Verfahren gemäß einem der vorhergehenden Ansprüche, wobei ein Vergleich der verschiedenen Messungen so durchgeführt wird, dass der Vergleich unabhängig von der Gesamtstärke ist, mit der der TE-Puls erfasst wird.

12. Vorrichtung oder Verfahren gemäß einem der vorhergehenden Ansprüche, wobei der Vergleich zwischen Messungen in den verschiedenen Frequenzbereichen auf einem Binning (150, 160) sowohl der Phase als auch der TE-Stärke beruht und die Zählungen von TE-Ereignissen in jedem Bin (150, 160) verwendet werden; und/oder wobei basierend auf einem Ergebnis des Vergleichs ausgewählte Frequenzbereiche von einer weiteren Analyse ausgeschlossen werden.

13. Vorrichtung oder Verfahren gemäß einem der vorhergehenden Ansprüche, wobei basierend auf einem Ergebnis des Vergleichs innerhalb bestimmter Regionen innerhalb eines PRPD-Musters die bestimmten Regionen von einer weiteren Analyse ausgeschlossen werden.

14. Vorrichtung oder Verfahren gemäß einem der vorhergehenden Ansprüche, wobei die verschiedenen Messungen zu einem Gesamt-PRPD-Muster kombiniert werden, das dann einem Bediener präsentiert oder als Grundlage für eine weitere Analyse verwendet wird.

15. Vorrichtung oder Verfahren gemäß einem der vorhergehenden Ansprüche, wobei die Vorrichtung ferner eine Netzwerkschnittstelle zum Verbinden der Vorrichtung mit einem Datennetzwerk umfasst, wobei die Vorrichtung operativ mit der Netzwerkschnittstelle für mindestens eines von Folgendem verbunden ist: Ausführen eines aus dem Datennetzwerk empfangenen Befehls und Senden von Vorrichtungsstatusinformationen an das Datennetzwerk.

## Revendications

1. Procédé (600) pour déterminer et traiter des motifs de décharges partielles résolus en phase, comprenant :
- la détermination (610), de manière séquentielle, sur au moins un conducteur à moyenne tension ou à haute tension, d'au moins deux motifs de décharges partielles résolus en phase par un système de surveillance de décharges partielles dans un compartiment à moyenne tension ou à haute tension dans différentes plages de fréquences ;
- le traitement (620), par une unité de traitement, des motifs de décharges partielles résolus en phase pour obtenir des données pouvant être traitées électroniquement ;
- le stockage (630) des données pouvant être traitées électroniquement du motif de décharges partielles résolu en phase dans une zone de mémoire, séparément pour chaque motif déterminé ;
- le traitement (640) des données des motifs de décharges partielles résolus en phase par l'unité de traitement de données électronique qui est en outre configurée pour classer les motifs, ou un sous-ensemble de ceux-ci, selon qu'ils contiennent principalement des décharges partielles ou des décharges partielles et des valeurs liées au bruit.

2. Procédé (600) selon la revendication 1, dans lequel les différentes plages de fréquences peuvent se situer dans une plage de fréquences acoustiques, mesurées par une unité de mesure conçue pour mesurer des signaux dans la plage de fréquences acoustiques, ou
dans lequel les plages de fréquences se situent dans une plage de fréquences RF.

3. Procédé (600) selon l'une quelconque des revendications précédentes, dans lequel les motifs de décharges partielles résolus en phase sont acquis de manière séquentielle ou de manière entrelacée.

4. Procédé (600) selon l'une quelconque des revendications précédentes, dans lequel le système de surveillance de décharges partielles est couplé électriquement à un coupleur qui est configuré pour recevoir des signaux électriques générés par une décharge partielle.

5. Procédé (600) selon l'une quelconque des revendications précédentes, la zone de mémoire étant une zone de mémoire dans l'unité de traitement de données, l'unité de traitement de données comprenant une CPU, une mémoire pour stocker des données et un code de programme, et des circuits d'entrée/sortie de données.

6. Dispositif conçu pour mettre en œuvre le procédé selon l'une quelconque des revendications précédentes, comprenant :
- un système de surveillance de décharges partielles, configuré pour déterminer séquentiellement, sur au moins un conducteur à moyenne tension ou à haute tension, au moins deux motifs de décharges partielles résolus en phase (170, 180) dans différentes plages de fréquences (110, 120, 130) ou acquis par l'intermédiaire d'un principe de mesure différent ;
- une unité de traitement, conçue pour traiter les motifs de décharges partielles résolus en phase afin d'obtenir des données pouvant être traitées électroniquement ;
- une zone de stockage, conçue pour stocker les données pouvant être traitées électroniquement du motif de décharges partielles résolu en phase (100, 200, 300, 400, 500), séparément dans une zone de mémoire pour chaque motif déterminé ;
- l'unité de traitement étant en outre conçue pour traiter les données des motifs de décharges partielles résolus en phase (100, 200, 300, 400, 500) afin de classer les motifs, selon qu'ils contiennent principalement des décharges partielles ou des décharges partielles et des valeurs liées au bruit.

7. Dispositif selon la revendication 6, dans lequel le système de surveillance de décharges partielles est couplé électriquement à un coupleur, qui est capable de recevoir des signaux électriques générés par une décharge partielle.

8. Dispositif selon l'une quelconque des revendications 6 à 7 précédentes, dans lequel la zone de mémoire est une zone de mémoire située dans l'unité de traitement de données, l'unité de traitement de données comprenant une CPU, une mémoire pour stocker des données et un code de programme, et des circuits d'entrée/sortie de données.

9. Dispositif ou procédé selon l'une quelconque des revendications précédentes, dans lequel l'unité de traitement est en outre configurée pour combiner des motifs, ou un ou plusieurs sous-ensembles de ceux-ci, classés comme contenant principalement des décharges partielles en un seul motif.

10. Dispositif ou procédé selon l'une quelconque des revendications précédentes, dans lequel la décision de savoir si une mesure est considérée comme contenant des valeurs liées au bruit est basée sur une métrique de distance, ou est basée sur un test statistique qui compare les uns aux autres les motifs de chaque plage de fréquences.

11. Dispositif ou procédé selon l'une quelconque des revendications précédentes, dans lequel une comparaison des différentes mesures est effectuée de telle sorte que la comparaison soit indépendante de l'intensité globale avec laquelle l'impulsion PD est acquise.

12. Dispositif ou procédé selon l'une quelconque des revendications précédentes, dans lequel la comparaison entre des mesures dans les différentes plages de fréquences repose sur un classement en cases (150, 160) à la fois de la phase et de l'intensité des PD et à l'utilisation des comptages d'événements de PD dans chaque case (150, 160) ; et/ou dans lequel, sur la base d'un résultat de la comparaison, des plages de fréquences sélectionnées sont exclues d'une analyse ultérieure.

13. Dispositif ou procédé selon l'une quelconque des revendications précédentes, dans lequel, sur la base d'un résultat de la comparaison dans certaines régions au sein d'un motif PRPD, lesdites certaines régions sont exclues d'une analyse ultérieure.

14. Dispositif ou procédé selon l'une quelconque des revendications précédentes, dans lequel les différentes mesures sont combinées en un motif PRPD global, qui est ensuite présenté à un opérateur ou est utilisé comme base pour une analyse ultérieure.

15. Dispositif ou procédé selon l'une quelconque des revendications précédentes, dans lequel le dispositif comprend en outre une interface réseau permettant de connecter le dispositif à un réseau de données, dans lequel le dispositif est fonctionnellement connecté à l'interface réseau pour au moins l'un : de la mise en œuvre d'une commande reçue en provenance du réseau de données et de l'envoi au réseau de données d'informations relatives à l'état du dispositif.
